Europäisches Patentamt

European Patent Office

Office européen des brevets

(19)

(11) EP 0 768 523 B1

(12) **EUROPEAN PATENT SPECIFICATION**

(45) Date of publication and mention
of the grant of the patent:
**09.06.2004 Bulletin 2004/24**

(51) Int Cl.⁷: **G01N 21/39, G01J 3/433**

(21) Application number: **96402127.3**

(22) Date of filing: **07.10.1996**

(54) **Method and system for sensitive detection of molecular species in a vacuum by harmonic spectroscopy**

Verfahren und System zur hochempfindlichen Detektion von molekularen Spezien unter Vakuum mittels Oberschwingungsspektroskopie

Procédé et système pour la détection sensible sous vide d'espèces moléculaires par spectroscopie harmonique

(84) Designated Contracting States:
**BE DE FR GB IT NL**

(30) Priority: **10.10.1995 US 5013**
**18.04.1996 US 634439**
**10.09.1996 US 711646**

(43) Date of publication of application:
**16.04.1997 Bulletin 1997/16**

(73) Proprietor: **L'air Liquide, S.A. à Directoire et Conseil de Surveillance pour l'Etude et l'Exploitation des Procédés Georges Claude 75321 Paris Cedex 07 (FR)**

(72) Inventors:
• **McAndrew, James J.F.**
**Lockport, Illinois 60441 (US)**
• **Inman, Ronald S.**
**Lyons, Illinois 60513 (US)**

(74) Representative: **Vesin, Jacques et al**
**L'Air Liquide**
**Service des Relations Industrielles**
**75, quai d'Orsay**
**75321 Paris Cédex 07 (FR)**

(56) References cited:
**WO-A-94/24528**

• **PODOLSKE J ET AL: "AIRBORNE TUNABLE DIODE LASER SPECTROMETER FOR TRACE-GAS MEASUREMENT IN THE LOWER STRATOSPHERE" APPLIED OPTICS, vol. 32, no. 27, 20 September 1993, pages 5324-5333, XP000393438**
• **FRIED ET AL: "APPLICATION OF TUNABLE DIODE LASER ABSORPTION FOR TRACE STRATOSPHERIC MEASUREMENTS OF HCL: LABORATORY RESULTS" APPLIED OPTICS, vol. 23, no. 11, June 1984, pages 1867-1880, XP002036453**
• **POKROWSKY P AND HERRMANN W: "SENSITIVE DETECTION OF HYDROGEN CHLORIDE BY DERIVATIVE SPECTROSCOPY WITH A DIODE LASER" OPTICAL ENGINEERING, vol. 23, no. 1, 1984, pages 088-091, XP002036454**
• **JASINSKI J ET AL: "DETECTION OF SIH2 IN SILANE AND DISILANE GLOW DISCHARGES BY FREQUENCY MODULATION ABSORPTION SPECTROSCOPY" APPLIED PHYSICS LETTERS, vol. 44, no. 12, June 1984, pages 1155-1157, XP002036448**
• **DAVIES P B ET AL: "INFRARED LASER DIAGNOSTICS IN METHANE CHEMICAL-VAPOR-DEPOSITION PLASMAS" JOURNAL OF APPLIED PHYSICS, vol. 71, no. 12, 15 June 1992, pages 6125-6135, XP000301544**

**Description**

BACKGROUND OF THE INVENTION

1. Field of the Invention

The present invention relates to a method for detecting gas phase molecular species in a sample by harmonic detection absorption spectroscopy, and to a method for detecting the same in a semiconductor processing apparatus. The present invention also relates to a system for detecting gas phase molecular species in a sample by harmonic detection absorption spectroscopy, and to a semiconductor processing apparatus comprising the same.

2. Description of the Related Art

Semiconductor integrated circuits (ICs) are manufactured by a series of processes, many of which involve the use of gaseous materials. Included among such processes are etching, diffusion, chemical vapor deposition (CVD), ion implantation, sputtering and rapid thermal processing. In these processes, contact is made between a semiconductor substrate and molecular species in the gas phase. As a result of the extremely fine features of the IC devices, parts per billion (ppb) and lower levels of impurities in the gases contacting the semiconductor substrates are usually considered necessary in order to minimize yield loss. Among the molecular impurities, moisture is extremely difficult to eliminate, and it adversely affects many semiconductor manufacturing processes.

A known method for detecting molecular species is infrared absorption spectroscopy. This method is based on the measurement of infrared light absorption which occurs at specific frequencies characteristic of a given molecule. However, when this method is used to measure trace quantities of molecular species inside a vacuum chamber, the measurement precision is often limited by light absorption due to the presence of the same species outside the chamber, where the light source and detector are disposed.

Three methods for mitigating the above described problem have been proposed. The first involves making the light path outside the vacuum chamber as short as possible relative to the path inside, the second is purging the light path outside the vacuum chamber with a pure gas and the third is to place this light path under vacuum. As used herein, the term "pure gas" refers to a gas with a moisture content of essentially zero. The second and third procedures can also be combined by evacuating prior to measurement.

However, these procedures are of limited effectiveness. For example, if the partial pressure of the molecular species of interest inside the vacuum chamber is very low, significant interference can still occur despite these precautions. In particular, when the molecular species of interest is water, components outside of the vacuum chamber often outgas water at a level sufficient to interfere with the measurement. In addition to outgassing, leaks and poorly purged volumes imposed by the geometry of the path outside the chamber can also contribute to the interference. These undesired sources of molecular species are extremely difficult or impossible to completely eliminate, thereby preventing accurate measurements from being made.

In infrared absorption spectroscopy, the absorption of light occurs with a spread about the center absorption frequency which increases linearly with pressure. Therefore, the width of the light absorption due to the molecules in the.higher pressure region outside of the vacuum chamber is greater than the width due to the molecules in the lower pressure region inside the vacuum chamber. Additionally, the maximum light absorption at the center frequency is directly proportional to the partial pressure of the species of interest and inversely proportional to the width of the transition. Consequently, as the total pressure of the gas outside the vacuum chamber is increased, the width of the transition also increases. When a simple infrared absorption measurement is used, no advantage is obtained by increasing the pressure outside of the vacuum chamber, even though the width of the signal due to molecules in that region is increased, because the partial pressure of the species of interest increases proportionately (assuming the concentration of the species remains constant), the signal due to the molecules outside the vacuum chamber is not suppressed because of the cancellation of the two effects. In fact, there would be a slight enhancement the size of which is dependent upon the Doppler linewidth. As a result, the molecular species in the light path outside of the vacuum chamber cannot be negated. Therefore infrared absorption spectroscopy is not suitable for precisely measuring trace quantities of the molecular species inside the vacuum chamber.

According to another known spectroscopic method, harmonic detection spectroscopy, the greater width of the transition due to molecules outside the vacuum chamber can be advantageously used. A more general discussion of the following may be found in C.R. Webster et al. Infrared Laser Absorption: *Theory and Applications* in Laser *Remote Chemical Analysis,* Wiley, New York (1988).

In the case where the water vapor is in an air or nitrogen matrix at a pressure of 1 atmosphere or higher, the shape of the absorption feature is described by the well-known Lorentz profile as follows:

$$I_0(v) - I(v) = \frac{1}{\pi} \frac{PclS\gamma}{(v-v_0)^2 + \gamma^2}$$

where $I_0(v)$ is the incident light intensity at frequency $v$, $I(v)$ is the transmitted light intensity at $v$, $P$ is the pressure, c is the volume concentration of water vapor, 1 is the length of the light path through the sample, S is the linestrength characteristic of the given absorption feature, $\gamma$ is the half-width of the absorption feature and $v_0$ is its center frequency. This expression gives a maximum light absorption:

$$I_0(v_0) - I(v_0) = \frac{1}{\pi} \frac{PclS}{\gamma}$$

when the frequency of the incident light is $v_0$.

In the case of infrared light absorption by water vapor under vacuum conditions, i.e., at a very low partial pressure (*e.g.,* less than about 13,33 Pa (0.1 torr), with a total gas pressure in the chamber of no more than about 66,66 Pa (0.5 torr), absorption features are much narrower. Absorption feature width is determined primarily by the Doppler effect, and results from the random motion of molecules with respect to the incident light, and is described by the following expression (Gaussian lineshape):

$$I_0(v) - I(v) = \frac{1}{\gamma_{ED}\sqrt{\pi}} \frac{PclS\gamma}{\exp\left(\frac{v-v_0}{\gamma_{ED}}\right)^2}$$

In the above equation, $\gamma_{ED}\sqrt{\ln(2)}$ is the half-width of the absorption feature under the above conditions, and depends on the center frequency of the absorption frequency, the molecular mass and the temperature. The line-center signal is given by the formula:

$$I_0(v_0) - I(v_0) = \frac{PclS}{\gamma_{ED}\sqrt{\pi}}$$

For water vapor under vacuum conditions and at room temperature i.e., about 25°C, $\gamma_{ED}$ is approximately equal to 0.01 cm$^{-1}$ for absorption of infrared light at frequencies near 7100 cm$^{-1}$ (where relatively strong absorption features accessible by convenient near-infrared diode laser sources are located). For water vapor in a matrix of air or nitrogen at one atmosphere pressure, a typical value of $\gamma$ is 0.1cm$^{-1}$. The value of $\gamma$ depends on the pressure and temperature of the gaseous sample and the center frequency of the absorption feature. For a given absorption feature at constant temperature, $\gamma$ is approximately described by the following formula:

$$\gamma = \gamma_{ED} + Pb$$

where b is a constant. A more accurate equation has been provided by Olivero and Longbotham, but the above is sufficient for purposes of this discussion.

In order to carry out harmonic detection, the frequency of the incident light source is modulated, with a sinusoidal modulation of amplitude a and frequency $\omega$ so that the frequency of light at time t is given by the expression:

$$v_{mod}(t) = v + a\cos\omega t$$

For first harmonic detection, that component of the signal at the detector which has a frequency $\omega$ and the same phase as the laser modulation is selected. This can be achieved, for example, by using a lock-in amplifier or by using a mixer to combine the detector output with a sinusoidal signal of frequency $\omega$, whose phase is suitably adjusted using a phase shifter, and passing the mixer output through a suitable low-pass filter. A detailed description may be found in *The Art of Electronics* by Horowitz and Hill. This technique is well-known and is used to remove noise components with a frequency of less than $\omega$ from the signal.

In second harmonic detection, the component of the signal with frequency $2\omega$ is selected, in third harmonic detection, the component of the signal with frequency $3\omega$ is selected, and so forth.

For the case of water vapor in nitrogen or air at one atmosphere pressure, the second harmonic signal at $v_0$ (line center) is given by the formula:

$$Signal(v_0) = \frac{2}{\pi} \frac{PclS}{\gamma} \int_0^\pi \frac{\cos(2\theta)\, d\theta}{\left(\frac{a\cos\theta}{\gamma}\right)^2 + 1}$$

Similarly, for the case of water vapor under vacuum conditions,

$$Signal(v_0) = \frac{2}{\sqrt{\pi}} \frac{PclS}{\gamma_{ED}} \int_0^\pi \frac{\cos(2\theta)\, d\theta}{\exp\left(\frac{a\cos\theta}{\gamma_{ED}}\right)^2}$$

These expressions were derived by G.V.H. Wilson, J. Appl. Phys. Vol. 34 No. 11 p. 3276 (1963), who also showed that the maximum value of *Signal ($v_0$)* is obtained when $a/\gamma$ (or $a/\gamma_{ED}$) = 2.2 for both cases.

Second harmonic spectroscopy may be implemented either by setting the frequency of light *v* emitted by the light source equal to the center frequency of the absorption feature $v_0$ or by repetitively scanning the frequency over a region which includes $v_0$. The former method usually requires active feedback control of the light source if it is a laser diode. In the latter case, scans over the entire absorption feature of interest are obtained. In either case, it is most advantageous if the signal at $v_0$ is primarily due to absorption by water molecules in the sample region of interest.

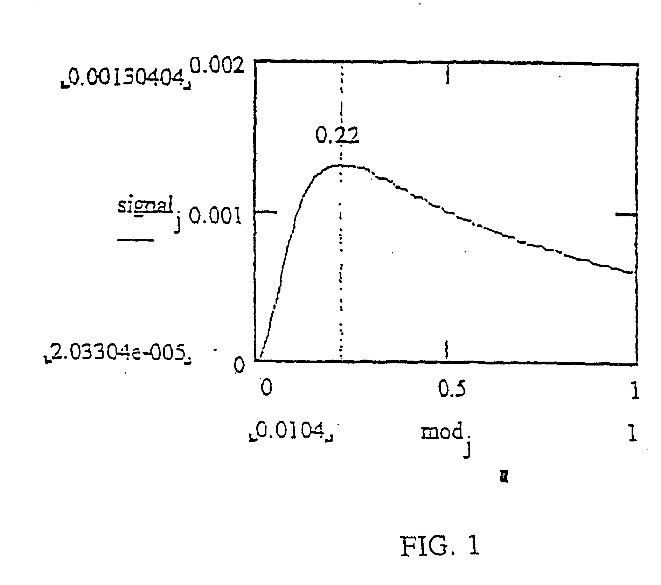

Figure 1 is a plot of *Signal$_j$*, which is obtained from *Signal ($v_0$)* by setting $\gamma = 0.1$, *PIS* = 1 (for ease of calculation, as only relative values are of interest), c = $10^{-6}$ and a = *mod$_j$*, where *mod$_j$* varies between 0 and 1. It can be seen from Figure 1 that *Signal$_j$* is a maximum when *mod$_j$* = 0.22 (i.e. 2.2•0.1), and that the signal becomes lower for smaller values of the modulation amplitude. It follows then, that for a sample under vacuum wherein the ambient outside the vacuum chamber is at atmospheric pressure, if the modulation amplitude is set to 2.2 times the width of the absorption due to the molecular species of interest inside the vacuum chamber, this modulation amplitude will necessarily be much less than the optimum value for the same molecular species outside the chamber.

However, in practice, when it is desired to detect a small partial pressure of a molecular species such as water in a vacuum chamber, and this species is present in the light path outside the chamber, a modulation amplitude which is less than the optimum value for detection of molecules inside the chamber has been used. Sub-optimum modulation amplitudes are purposely chosen as they further suppress the signal due to the higher pressure molecules outside the vacuum chamber.

The above advantages of harmonic spectroscopy for suppressing signals due to molecules at atmospheric pressure in the light path outside the chamber has been recognized by Mucha, ISA Transactions, Vol.25, No.3, p.25 (1986). Mucha further notes the existence of an optimum modulation amplitude which balances suppression of the atmospheric pressure signals with optimization of the signals due to molecules inside the vacuum chamber. In this regard, in previous work of the presently named inventors, Inman et al, *Application of Tunable Diode Laser Absorption Spectroscopy to Trace Moisture Measurements in Gases,* Anal. Chem., Vol.66, No.15, pp.2471-2479 (1994), the Mucha technique was implemented by applying modulation amplitudes from 1.3 to 1.8 times the linewidth due to species inside the chamber.

Podolska J. et al, Applied Optics, vol. 32, n° 27, 20 September 1993, pages 5324-5333, describes the use of layer- wavelength modulation and second-harmonic detection in layer absorption spectrometer for in-situ trace gas-measurement in the lower stratosphere.

However, as a result of the use of sub-optimum modulation amplitudes, this technique suffers the disadvantage of a considerable signal loss by up to a factor of four when compared with the signal theoretically obtainable, resulting in a lack of sensitivity and ability to measure trace quantities of molecular species inside a vacuum chamber.

To meet the requirements of the semiconductor processing industry and to overcome the disadvantages of the prior art, it is an object of the present invention to provide a novel method for detecting gas phase molecular species in a sample by harmonic detection spectroscopy which will allow for accurate *in situ* determination of gas phase molecular species in a sample at a level at least as low as in the ppb range.

It is a further object of the present invention to provide a method for detecting gas phase molecular species in a semiconductor processing apparatus by harmonic detection spectroscopy, using the inventive method.

It is a further object of the present invention to provide a system for detecting gas phase molecular species in a sample by harmonic detection spectroscopy, for practicing the inventive method.

It is a further object of the present invention to provide a semiconductor processing apparatus which includes the inventive system for detecting gas phase molecular species in a sample by harmonic detection spectroscopy.

Other objects and aspects of the present invention will become apparent to one of ordinary skill in the art on a review of the specification, drawings and claims appended hereto.

SUMMARY OF THE INVENTION

The foregoing objectives are achieved by the method in accordance with claim 1 and the system in accordance with claim 16. Accordingly a novel method for detecting gas phase molecular species in a sample by harmonic detection spectroscopy is provided. The method comprises providing a cell having a sample region which is circumscribed by at least one wall. The cell has at least one light entry/exit port, with each entry/exit port containing a light transmissive window having a surface facing the sample region and disposed so as to seal the cell in the circumferential direction. A sample gas flows through the sample region in a direction parallel to a cell central axis, and the cell operates at less than atmospheric pressure.

A frequency (or wavelength) modulated light source is provided for directing a light beam through one of the at least one light transmissive windows into the cell. The light source modulation amplitude is set to a value which approximately maximizes the value of a harmonic signal at the center of the absorption feature due to the detected gas phase molecular species inside the sample region. The center frequency of the light source is adjusted so that it is either locked to the center of the absorption feature or repetitively scanned over the frequency range which includes the feature. A spectra is then generated which may be recorded individually or averaged.

A detector is provided for measuring the light beam exiting the cell through one of the at least one light transmissive windows. The light source and detector are contained within a chamber which is external to the cell and isolated from the sample region, the chamber and the sample region being placed in optical communication with each other through at least one of the at least one light transmissive windows. The pressure inside the chamber is controlled to a value which is positive relative to atmospheric pressure.

BRIEF DESCRIPTION OF THE DRAWINGS

The objects and advantages of the invention will become apparent from the following detailed description of the preferred embodiments thereof in connection with the accompanying drawings, in which like numerals designate like elements, and in which:

FIG. 1 is a graph that depicts the second harmonic signal at the center of the absorption region for a total pressure of 1 atmosphere versus modulation amplitude.

FIGS. 2A and 2B illustrate a cross-sectional and perspective view, respectively, of a system for detecting gas phase molecular species according to the present invention.

FIG. 3 is a comparative graph that depicts the ratio of the second harmonic signal due to water molecules in the outer chamber to that in the inner chamber versus pressure in the outer chamber for three inner chamber water molecule partial pressures.

FIG. 4 is a comparative graph that depicts the ratio of the fourth harmonic signal due to water molecules in the outer chamber to that in the inner chamber versus pressure in the outer chamber for three inner chamber water molecule partial pressures.

FIG. 5 is a comparative graph that depicts the ratio of the signal due to water molecules in the outer chamber to that in the inner chamber versus pressure in the outer chamber for second and fourth harmonic detection, and for detection with no modulation of the light source frequency.

FIG. 6 illustrates in cross-section, a semiconductor processing apparatus which includes the system for detecting gas phase molecular species according to the present invention.

DETAILED DESCRIPTION OF THE PREFERRED EMBODIMENTS OF THE INVENTION

The harmonic detection spectroscopy method of the present invention includes providing a cell having a sample region which is circumscribed by at least one wall. The cell has at least one light entry/exit port therein, and each entry/exit port contains a light transmissive window having a surface facing the sample region and disposed so as to seal the cell in the circumferential direction. A sample gas flows through the sample region in a direction parallel to a cell central axis, and the cell operates at less than atmospheric pressure.

A frequency (or wavelength) modulated light source is provided for directing a light beam through one of the at least one light transmissive windows into the cell. The light source modulation amplitude is set to a value which approximately maximizes the value of a harmonic signal at the center of the absorption feature due to the detected gas phase molecular species inside the sample region. For example, in the case of the second harmonic this value is approximately 2.2 times the width of the spectral feature due to the detected gas phase molecular species inside the sample region. For the fourth harmonic, this value is approximately 3.9 times the width of the spectral feature due to the detected gas phase molecular species inside the sample region.

The center frequency of the light source, i.e., that frequency about which modulation occurs, may either be locked to the center of the absorption feature or may be repetitively scanned over the frequency range which includes the feature. Spectra are generated which may be recorded individually or averaged as desired. When the center frequency is repetitively scanned over the spectral region of interest, such scans should occur at a rate which is slow compared to the modulation frequency.

A detector is provided for measuring the light beam exiting the cell through one of the at least one light transmissive windows. The light source and detector are contained within a chamber which is external to the cell and isolated from the sample region. The chamber and the sample region are placed in optical communication with each other through at least one of the at least one light transmissive windows. The pressure inside the chamber is controlled to a value which is positive relative to atmospheric pressure.

The methods and system of the present invention are particularly well suited for overcoming the problems associated with spectroscopic measurements of molecular species in a vacuum chamber. These problems stem in part from interference due to light absorption caused by the presence of the same molecular species in the light path external to the vacuum chamber. In particular, by the present invention, Applicants have prevented or minimized the adverse effects caused by this interference by containing in a pressurized chamber that portion of the light path which is located outside of the vacuum chamber/measurement cell. The pressurized chamber is suitable for operation under positive pressures relative to atmospheric pressure.

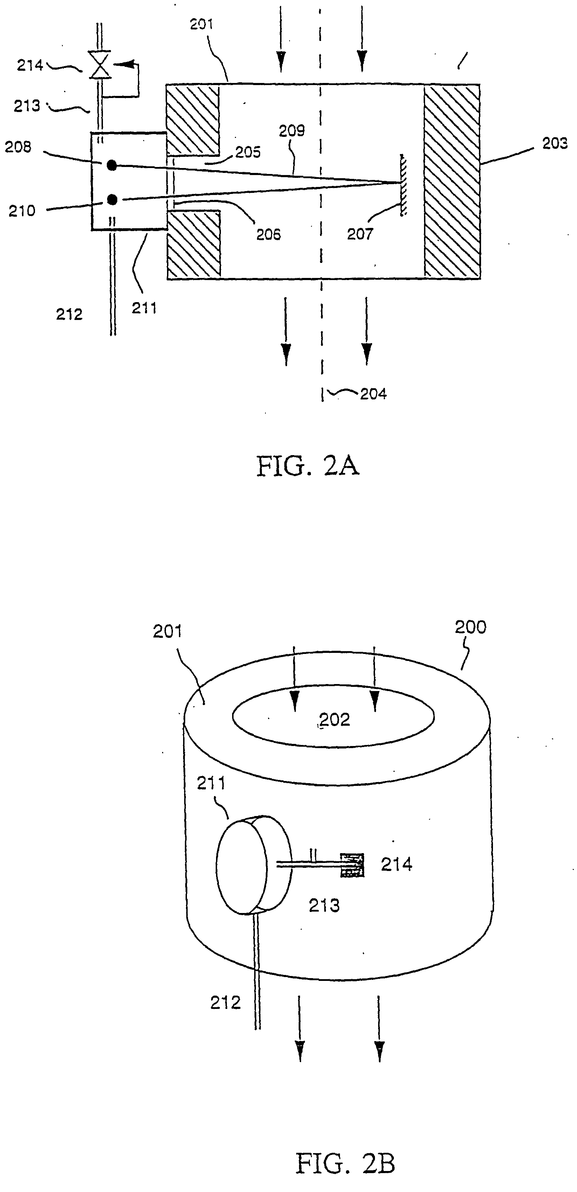

One aspect of the present invention will now be discussed with reference to Figs. 2A and 2B, which illustrate in cross-sectional and perspective views, respectively, a system for detecting gas phase molecular species.

The inventive system 200 comprises an absorption spectroscopy cell 201 which allows for in situ detection of molecular species in a gas sample. The cell 201 has a sample region 202 which contains a sample to be measured. The sample region is circumscribed by a wall or a plurality of walls 203. The cell 201 further includes an opening extending along the longitudinal axis 204 thereof which extends through the cell. This arrangement allows a sample to pass through the cell in the direction parallel to the cell central axis (indicated by arrows).

One or more light entry/exit ports 205 are included in the walls of the cell, with each entry/exit port containing a light transmissive window 206 which faces the sample region. Together, the cell walls and light transmissive windows seal the cell in the circumferential direction. To form a seal suitable for vacuum environments, an O-ring or other conventional vacuum sealing material can be used.

The cell further comprises at least one light reflective surface 207 such as a mirror for reflecting a light beam within the cell 201. This light reflective surface 207 is preferably a polished metal.

Also included in the system is a light source 208 which can be a frequency modulated light source, preferably a diode laser. Light source 208 directs a light beam 209 through a light transmissive window 206 into the cell sample region 202, where the beam is reflected from light reflective surface 207.

Any molecular impurity of interest can be detected, subject only to the availability of a suitable light source. For example, water vapor, nitric oxide, carbon monoxide and methane or other hydrocarbons can be detected by measuring the attenuation of light from a diode laser source which emits light of a wavelength characteristic of the impurity.

Laser light sources which emit light in spectral regions where the molecules of interest absorb most strongly lead to improvements in measurement sensitivity. In particular, light sources which emit at wavelengths longer than about $2\mu m$ are preferred, since many of the molecular impurities of interest have strong absorption bands in this region.

Any suitable wavelength-tunable light source can be used. Of the currently available light sources, diode laser light sources are preferred because of their narrow linewidth (less than about $10^{-3}cm^{-1}$) and relatively high intensity (about 0.1 to several milliwatts) at the emission wavelength.

Examples of diode lasers include Pb-salt and GaAs-type diode lasers. The Pb-salt-type laser requires cryogenic temperatures for operation and emits infrared light (i.e., wavelength greater than $3\mu m$), while the GaAs-type diode laser can operate at close to room temperature and emits in the near infrared region (0.8-$2\mu m$).

Recently, diode lasers which include Sb in addition to GaAs (or other pairs of III-V compounds such as AsP) have been described (see, "Mid-infrared wavelengths enhance trace gas sensing," R. Martinelli, Laser Focus World, March 1996, p. 77). These diodes emit light of a wavelength greater than $2\mu m$ while operating at -87.8°C. While such a low temperature is not convenient, it compares favorably with the cryogenic temperatures (less than -170°C) required by Pb-salt lasers. Operation of similar lasers at $4\ \mu m$ and 12°C has also been reported (see, Lasers and Optronics, March 1996). Diode lasers of the above described type will most preferably operate at temperatures of at least -40°C. Use of a thermoelectric cooler for temperature control at such temperatures makes these light sources less complicated than the lower temperature diode systems. To make use of these lasers more desirable, improvement in the optical properties over current levels is important. For example, single mode diodes (i.e., diodes whose emission at fixed temperature and drive current is at a single wavelength with emission at other wavelengths at least 40 dB less intense) should be available.

Suitable light sources for use in the invention are not limited to the above described diode lasers. For example, other types of lasers which are similarly sized and tunable by simple electrical means, such as fiber lasers and quantum cascade lasers, are envisioned. The use of such lasers as they become commercially available is envisioned.

The light source modulation amplitude is set a value which approximately maximizes the value of a harmonic signal at the center of the absorption feature due to the detected gas phase molecular species in the sample region. This value is 2.2 times the width of the spectral feature due to the detected gas phase molecular species inside the sample region, for the second harmonic. For the fourth harmonic, this value is 3.9 times the width of the spectral feature.

The center frequency of the light source, i.e., that frequency about which modulation occurs, may either be locked to the center of the absorption feature or may be repetitively scanned over the frequency range which includes the feature. Spectra are generated which may be recorded individually or averaged as desired. When the center frequency is repetitively scanned over the spectral region of interest, such scans should occur at a rate which is slow compared to the modulation frequency.

To detect the light beam 209 after it passes through the sample region and exits the cell through the light transmissive window, detector 210, which is preferably a photodiode, is provided.

Those skilled in the art will readily be able to design the appropriate means for performing frequency modulation, the means for adjusting the center frequency of the light source and the means for generating spectra by use of well known devices, circuits and/or processors and means for their control. Further discussion of the facilitation of frequency modulation and/or control and spectra generation is omitted as it is deemed within the scope of those of ordinary skill in the art.

Both the light source 208 and detector 210 are contained within a pressurized chamber 211 which is disposed external to the cell 201. To allow the light beam to pass between the pressurized chamber and the cell sample region, the pressurized chamber and the sample region are in optical communication with each other through at least one light transmissive window. However,. the respective atmospheres within the pressurized chamber and sample region are isolated from each other.

The system can further include means for controlling the pressure inside the pressurized chamber 211 to a value which is positive relative to atmospheric pressure. The pressure level in the pressurized chamber can be maintained either with or without the use of a gas flow. Should a gas flow be used, suitable gases include pure or inert gases such as, e.g., nitrogen, argon and helium. These gases can be introduced into the pressurized chamber 211 through a pressurizing gas inlet line 212. The pressurized chamber can further include a gas exhaust line 213. In addition, a suitable gas flow restrictor 214, such as an orifice or a back-pressure regulator can be included on the gas exhaust line.

When used in series with a vacuum chamber and vacuum pump system, the cell is capable of operation at less than atmospheric pressure, i.e., under vacuum conditions. In this case, because the pressurized chamber 211 and cell 201 are isolated from one another, the pressurized chamber can be maintained at pressures above atmospheric pressure.

It has further been determined that by optimizing the ratio of the pressure inside the pressurized chamber to the pressure inside the cell, the percentage of total signal due to molecules in the inner chamber can be maximized relative to the total signal due to molecules in the outer chamber. The ratio of the second harmonic signal due to molecules outside the chamber to the total signal is provided by.the following formula:

$$secharm_j = \frac{\left|\int_0^\pi \frac{P_j \cdot \cos(2\cdot\theta)}{\left[\left(\frac{a\cdot\cos(\theta)}{\gamma_j}\right)^2 + 1\right]} d\theta\right| \cdot \frac{1}{\pi\cdot\gamma_j}}{\left|\int_0^\pi \frac{P_j \cdot \cos(2\cdot\theta)}{\left[\left(\frac{a\cdot\cos(\theta)}{\gamma_j}\right)^2 + 1\right]} d\theta\right| \cdot \frac{1}{\pi\cdot\gamma_j} + \left|\int_0^\pi \frac{\cos(2\cdot\theta)}{\exp\left[\frac{(a\cdot\cos(\theta))^2}{\gamma ED}\right]} d\theta\right| \cdot \frac{1}{\gamma ED\cdot\pi}}$$

The numerator is equivalent to the expression given previously for the second harmonic signal due to water vapor in the presence of one atmosphere or higher pressure of air or nitrogen. The denominator is the sum of the same expression with the previously given expression for the second harmonic signal due to water vapor under vacuum conditions.

Likewise, the fourth harmonic signal for the same case is given by the formula:

$$fourharm_j = \frac{\left|\int_0^\pi \frac{P_j \cdot \cos(4\cdot\theta)}{\left[\left(\frac{v - a\cdot\cos(\theta)}{\gamma_j}\right)^2 + 1\right]} d\theta\right| \cdot \frac{1}{\pi\cdot\gamma_j}}{\left|\int_0^\pi \frac{P_j \cdot \cos(4\cdot\theta)}{\left[\left(\frac{v - a\cdot\cos(\theta)}{\gamma_j}\right)^2 + 1\right]} d\theta\right| \cdot \frac{1}{\pi\cdot\gamma_j} + \left|\int_0^\pi \frac{\cos(4\cdot\theta)}{\exp\left[\frac{(v - a\cdot\cos(\theta))^2}{\gamma ED}\right]} d\theta\right| \cdot \frac{1}{\gamma ED\cdot\pi}}$$

For the above, it has been assumed that the pathlength and water partial pressure inside and outside the cell are equal when the pressure outside the cell is one atmosphere, and that the concentration of water vapor outside the cell remains constant as the pressure in that region increases ($P_j$ is in atmospheres). However, extension of these principles to the case where the pathlengths and water partial pressure are unequal is within the level of knowledge of persons having ordinary skill in the art. The modulation amplitude a is assumed to be 2.2 times the Doppler width in the situation in which the second harmonic is being used.

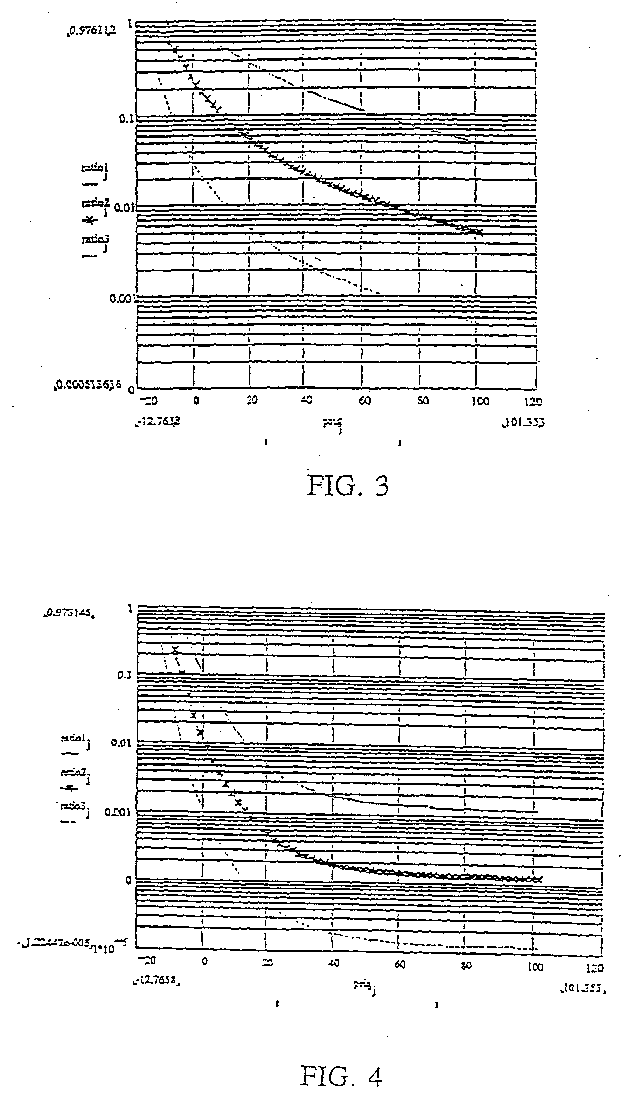

As shown in Fig. 3, the above formula was evaluated using values of the parameters appropriate for absorption of light at wavelengths in the region of 1400 nm, due to water vapor, for a concentration of water vapor of 1 ppm (by volume) in nitrogen in the pressurized chamber, and for partial pressures of $1,33.10^{-4}$, $1,33.10^{-3}$ and $1,33.10^{-2}$ Pa ($10^{-6}$, $10^{-5}$ and $10^{-4}$ torr) (ratio 1, ratio 2, and ratio 3, respectively) inside the cell/vacuum chamber. In Fig. 3, the ratio of the second harmonic signal due to water molecules in the outer chamber to the signal in the inner chamber is plotted versus pressure in the pressurized chamber for the three inner chamber partial pressures.

This graph illustrates the general relationship of a decrease in the ratio (i.e., an increase in the signal due to water inside the cell relative to that due to water in the pressurized chamber) with an increase in pressure in the pressurized chamber. For example, for a chamber pressure of one atmosphere ($10^5$ Pa) (0 psig) and a water vapor pressure in the cell/vacuum chamber of $1,33.10^{-4}$ Pa ($10^{-6}$ torr), 80% of the total signal will be due to water molecules in the pressurized chamber. This ratio is not acceptable, as it will result in a substantial amount of interference in the measurement unless the partial pressure of the water molecules is exceptionally stable.

Thus, in order to use the optimum modulation amplitude the pressure in the outer chamber should be made as high as possible, but at least $5,48.10^5$ Pa (65 psig) in order to reduce the contribution from water there to 10% of the total. In addition, for a water vapor partial pressure of $1,33.10^{-2}$ Pa ($10^{-4}$ torr) in the cell/vacuum chamber, water in the pressurized chamber will account for only 3% of the total signal at atmospheric pressure, and operation under these conditions may be feasible. However, as shown in Fig. 3, by increasing the outer pressure to $2,379.10^5$ Pa (20 psig) one would expect a substantial reduction in the contribution from water molecules in the outer chamber to 0.6% of the total. Further increases in the pressure inside the pressurized chamber in this case would be unlikely to lead to additional benefit since other sources of instability that will lead to fluctuations in the signal on the order of 1% can be expected. The pressure in the cell is preferably less than 1 torr, although some benefit of the invention is obtained at cell pressures up to $10^5$ Pa (1 atmosphere), and between $10^5$ and $5.10^5$ Pa (1 and 5 atmospheres) in the chamber.

It has been found that particularly beneficial and unexpected results can be obtained when harmonics other than the second are applied to the present invention. In fact, higher harmonics were found to provide an even better suppression of the signal due to the molecular species in the pressurized chamber as the pressure therein is increased.

FIG. 4 is a comparative graph depicting the results obtained for detection of the fourth harmonic from the analogous calculation to that discussed above in reference to Fig. 3, which relates to the second harmonic. In Fig. 4, the ratio of the fourth harmonic signal due to water molecules in the pressurized chamber to that in the inner chamber is plotted against pressure in the pressurized chamber for three inner chamber water molecule partial pressures of $1,33.10^{-4}$, $1,33.10^{-3}$ and $1,33.10^{-2}$ Pa ($10^{-6}$, $10^{-5}$ and $10^{-4}$ torr) (ratio 1, ratio 2, and ratio 3, respectively). As can be seen from this figure, the fourth harmonic generally shows a decrease in the ratio with an increase in pressure of the pressurized chamber. However, for increases beyond a certain pressure, this ratio becomes relatively constant, and further increases in pressure would not lead to further substantial reductions in the ratio.

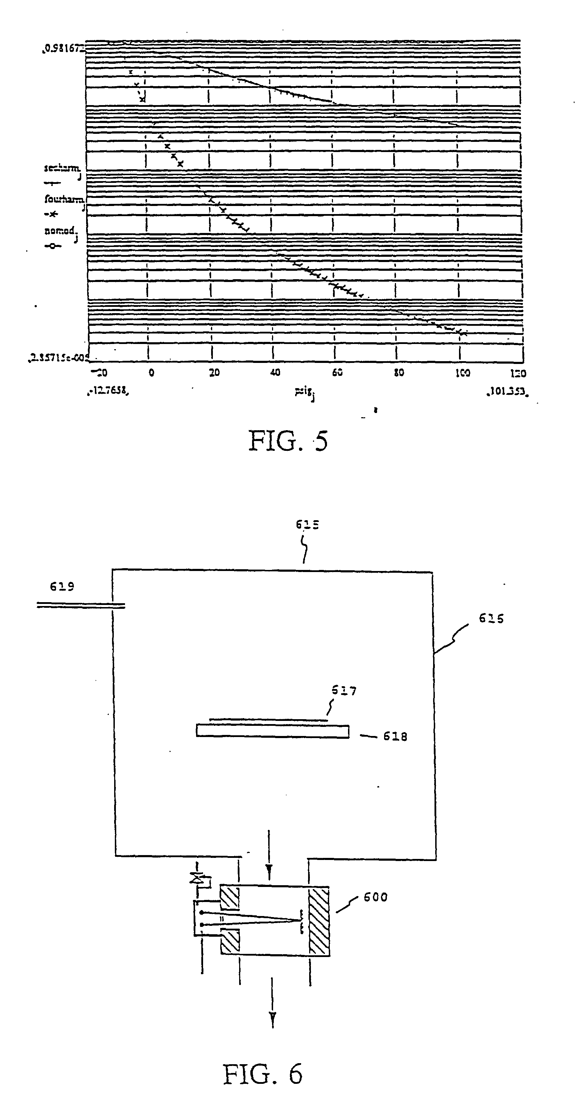

Figure 5 illustrates the relative benefit of pressurizing the outer chamber for the case of second harmonic detection (secharm), fourth harmonic detection (fourharm) and detection without any modulation of the light source frequency (nomod), for the case where the partial pressure of water and the pathlength in the inner and the outer chamber are equal. It can be seen that where there is no modulation, no advantage is obtained from pressurization. Second harmonic detection with atmospheric pressure in the outer chamber results in 80% absorption by water in the outer chamber, which, as mentioned previously, is unacceptable. Increasing the outer chamber pressure to $5,48.10^5$ Pa (65 psig) will result in a contribution of 10% of the total signal from water vapor in this chamber, which should be acceptable. However, it is preferable in this case to use fourth harmonic detection, which, even when the pressure in the outer chamber is one atmosphere, leads to a contribution of 10% by water vapor in that chamber, and, when coupled with a modest pressurization of $2,03.10^5$ Pa (15 psig) of the outer chamber, can reduce the contribution from water in that chamber to less than 1%.

The novel system described above allows for in situ detection of molecular species in a gas exhausted from a vacuum chamber, and has the capability of operation at up to high or even ultra-high vacuum levels. In such a case, the cell can be disposed between a vacuum chamber and vacuum pump system. The system is compatible with a wide range of materials. For example, the vacuum chamber can contain reactive or nonreactive (inert) gases which can be in a plasma- or non-plasma state. Examples of reactive gases which are compatible with the inventive system include $SiH_4$ HCl and $Cl_2$ provided the moisture level is less than 1000 ppm. Inert gases such as, e.g., $O_2$, $N_2$, Ar and $H_2$ can also be used in the inventive system. In the case of the inventive system's use in a plasma environment, the system is preferably mounted about 0,1524 m (6 inches) or more away from the plasma zone in order to minimize formation of deposits on the windows and other cell surfaces.

Because the system described above in reference to Figs. 2A and 2B can be used in a variety of atmospheres, the system is particularly well suited for use in monitoring molecular species in a semiconductor processing apparatus. Use of the system in conjunction with a semiconductor processing apparatus allows for real-time in situ detection of gas phase molecular impurities which is of particular importance in minimizing yield loss.

One example of such a configuration is shown in Fig. 6. The illustrated apparatus 615 comprises a vacuum chamber 616 inside which a semiconductor substrate 617 is disposed on a substrate holder 618. A process gas inlet 619 is provided for delivering a gas or plural gases to the vacuum chamber. The vacuum chamber is evacuated through an exhaust opening 620 in the vacuum chamber. A vacuum pump (not shown) for evacuating the vacuum chamber is connected to the chamber, either directly or through a vacuum line. A pump exhaust line can be connected to the pump, which can be connected to another pump or to a gas scrubber. Examples of vacuum pumps which may be employed are mechanical, booster and rotary pumps, diffusion pumps, cryogenic pumps, sorption pumps and turbomolecular pumps. The system has been described in detail above in reference to Figs. 2A and 2B.

While the inventive system 600 has been illustrated as being disposed below the vacuum chamber, those skilled in the art will readily appreciate that other orientations are also possible. While the structure of the semiconductor processing apparatus has been shown generically in Fig. 6, persons skilled in the art will readily appreciate that the system can be adapted to virtually any of the semiconductor processing apparatuses employing a vacuum system. Examples of such apparatuses are etching, diffusion, chemical vapor deposition (CVD), ion implantation, sputtering and rapid thermal processing apparatuses.

While the invention has been described in detail with reference to specific embodiments thereof, it will be apparent to one skilled in the art that various changes and modifications can be made, and equivalents employed, without departing from the scope of the appended claims.

**Claims**

1. A method for detecting gas phase molecular species in a sample by harmonic detection spectroscopy, comprising :

   - providing a cell (201) having a sample region (202) which is circumscribed by at least one wall (203), the cell (201) having at least one light entry/exit port (205) therein, each entry/exit port (205) containing a light transmissive window (206) having a surface facing the sample region (202) and disposed so as to seal the cell (201) in the circumferential direction, the cell (201) operating at atmospheric pressure or less;
   - providing a frequency and/or amplitude modulated light source (208) for directing a light beam (209) through one of the at least one light transmissive windows (206) into the cell (201) ;
   - providing a detector (210) for measuring the light beam (209) exiting the cell (201) through one of the at least one light transmissive windows (206) ;

   wherein:

   - a sample gas flows through the sample region (202) in a direction parallel to a cell central axis (204) ;
   - the light source (208) modulation amplitude is set to a value which maximizes the value of a harmonic signal at the center of the absorption feature due to the detected gas phase molecular species inside the sample region (202) ;
   - the center frequency of the light source (208) is adjusted so that it is either locked to the center of the absorption feature or repetitively scanned over the frequency range which includes the feature, generating spectra which may be recorded individually or averaged as desired ;
   - the light source (208) and detector (210) are contained within a chamber (211) which is external to the cell (201) and isolated from the sample region (202), the chamber (211) and the sample region (202) being placed in optical communication with each other through at least one of the at least one light transmissive windows (206), and controlling the pressure inside the chamber (211) to a value which is positive relative to atmospheric pressure.

2. The method for detecting gas phase molecular species according to Claim 1, wherein the harmonic signal is a second harmonic signal, and the modulation amplitude is set to 2.2 times the width of the spectral absorption feature due to the detected gas phase molecular species in the sample region (202).

3. The method for detecting gas phase molecular species according to Claim 1, wherein the harmonic signal is a fourth harmonic signal, and the modulation amplitude is set to 3.9 times the width of the spectral absorption feature due to the detected gas phase molecular species in the sample region (202).

4. The method for detecting gas phase molecular species according to one of claims 1 to 3, further comprising controlling the pressure inside the chamber (211) to maximize the percentage of the measured signal due to the detected gas phase molecular species in the chamber (211).

5. The method for detecting gas phase molecular species according to claim 4, wherein the chamber (211) pressure is controlled by use of an orifice or a back pressure regulator.

6. The method for detecting gas phase molecular species according to one of claims 1 to 5, further comprising introducing a pressurizing gas into the chamber (211) and optionally exhausting gas from the chamber (211).

7. The method for detecting gas phase molecular species according to one of claims 1 to 6, wherein the frequency and/or modulated light source (208) is a diode laser.

8. The method for detecting gas phase molecular species according to one of claims 1 to 7, wherein the molecular species is water vapor.

9. The method for detecting gas phase molecular species according to one of claims 1 to 8, wherein the molecular species is detected in a gas exhausted from a chamber (616), or from a chamber operated at approximately atmospheric pressure.

10. The method for detecting gas phase molecular species according to claim 9, wherein the cell (201) is disposed between and in communication with a chamber (616) and a vacuum pump.

11. The method for detecting gas phase molecular species according to claim 10, wherein the chamber (616) forms a portion of a semiconductor processing apparatus (615).

12. The method for detecting gas phase molecular species according to claim 11, wherein the semiconductor processing apparatus (615) is selected from the group consisting of an etching apparatus, a chemical vapor deposition apparatus, an ion implantation apparatus, a sputtering apparatus and a rapid thermal processing apparatus.

13. The method for detecting gas phase molecular species according to one of claims 1 to 12, further comprising generating a plasma in the chamber (616).

14. The method for detecting gas phase molecular species according to one of claims 1 to 13, further comprising introducing a reactive gas into the chamber (616).

15. The method for detecting gas phase molecular species according to claim 11, wherein the vacuum pump evacuates the chamber (616).

16. A system for detecting gas phase molecular species in a sample by harmonic detection spectroscopy, comprising :

- a cell (201) having a sample region (202) which is circumscribed by at least one wall (203), and at least one light entry/exit port (205) therein, each entry/exit port (205) containing a light transmissive window (206) having a surface facing the sample region (202) and disposed so as to seal the cell (201) in the circumferential direction, the cell (201) being capable of operation at less than atmospheric pressure,
- a frequency and/or amplitude modulated light source (208) system comprising a light source (208) for directing a light beam (209) through one of the at least one light transmissive windows (206) into the cell (201),
- a detector (210) for measuring the light beam (209) exiting the cell (201) through one of the at least one light transmissive windows (206),

wherein :

- an opening extends along the longitudinal axis (204) of said cell and through said cell (201) ;
- this system comprises means for setting the light source (208) modulation amplitude to a value which maximizes the value of a harmonic signal at the center of the absorption feature due to the detected gas phase molecular species inside the sample region (202) ;
- this system comprises means for adjusting the center frequency of the light source (208) so that it is either locked to the center of the absorption feature or repetitively scanned over the frequency range which includes the feature, means for generating spectra which may be recorded individually or averaged ;
- the light source (208) and detector (210) are contained within a chamber (211) which is external to the cell (201) and isolated from the sample region (202), the chamber (211) and the sample region (202) being in optical communication with each other through at least one of the at least one light transmissive windows (206), and means for controlling the pressure inside the chamber (211) to a value which is positive relative to atmospheric pressure.

17. The system for detecting gas phase molecular species according to claim 16, wherein the harmonic signal is a second harmonic signal, and the modulation amplitude is 2.2 times the width of the spectral absorption feature due to the detected gas phase molecular species in the sample region (202).

18. The system for detecting gas phase molecular species according to claim 16, wherein the harmonic signal is a fourth harmonic signal, and the modulation amplitude optimum value is 3.9 times the width of the spectral absorption feature due to the detected gas phase molecular species in the sample region (202).

19. The system for detecting gas phase molecular species according to one of claims 16 to 18, wherein the pressure inside the chamber (211) is set to maximize the percentage of a total signal due to the detected gas phase molecular species in the chamber (211).

20. The system for detecting gas phase molecular species according to one of claims 16 to 19, wherein the chamber (211) pressure control means comprises a pressurizing gas inlet and an exhaust gas outlet connected to the chamber (211).

21. The system for detecting gas phase molecular species according to claim 16, wherein the chamber (211) pressure control means further comprises an orifice or a back pressure regulator.

22. The system for detecting gas phase molecular species according to one of claims 16 to 21, wherein the frequency and/or modulated light source (208) is a diode laser.

23. A semiconductor processing apparatus (615), comprising:

- a chamber (616) and a vacuum pump in communication therewith for evacuating said chamber;
- a system according to one of the claims 16 to 22, with the cell (201) placed between and in communication with said chamber (616) and said vacuum pump.

24. The apparatus according to claim 23, wherein the chamber (616) is adapted to contain a plasma atmosphere.

25. The apparatus according to claim 23 or 24, wherein the chamber (616) is adapted to contain a reactive gas atmosphere.

26. Etching apparatus comprising an apparatus according to one of claims 23 to 25.

27. Chemical vapour deposition apparatus comprising an apparatus according to one of claims 23 to 25.

28. Ion implantation apparatus comprising an apparatus according to one of claims 23 to 25.

29. Sputtering apparatus comprising an apparatus according to one of claims 23 to 25.

30. Rapid thermal processing apparatus comprising an apparatus according to one of claims 23 to 25.

**Patentansprüche**

1. Verfahren zum Erfassen von Gasphasen-Molekülspezies in einer Probe durch Oberwellendetektionsspektroskopie, umfassend:

- Bereitstellen einer Zelle (201) mit einem Probengebiet (202), das von mindestens einer Wand (203) umschrieben wird, wobei sich in der Zelle (201) mindestens ein Lichteintritts-/-austrittskanal (205) befindet, wobei jeder Eintritts-/Austrittskanal (205) ein lichtdurchlässiges Fenster (206) mit einer Oberfläche aufweist, die dem Probengebiet (202) zugewandt ist und so angeordnet ist, daß sie die Zelle (201) in Umfangsrichtung abdichtet, wobei die Zelle (201) bei atmosphärischem Druck oder weniger arbeitet;
- Bereitstellen einer frequenz- und/oder amplitudenmodulierten Lichtquelle (208) zum Lenken eines Lichtstrahls (209) durch eines des mindestens einen lichtdurchlässigen Fensters (206) in die Zelle (201);
- Bereitstellen eines Detektors (210) zum Messen des Lichtstrahls (209), der durch eines des mindestens einen lichtdurchlässigen Fensters (206) aus der Zelle (201) austritt;

wobei:

- ein Probengas durch das Probengebiet (202) in eine Richtung parallel zu einer Zellenmittelachse (204) strömt;
- die Modulationsamplitude der Lichtquelle (208) auf einen Wert eingestellt ist, der den Wert eines Oberwellensignals in der Mitte des Absorptionsmerkmals aufgrund der detektierten Gasphasen-Molekülspezies im Probengebiet (202) maximiert;
- die Mittenfrequenz der Lichtquelle (208) so justiert ist, daß sie entweder auf die Mitte des Absorptionsmerkmals synchronisiert ist oder wiederholt den Frequenzbereich überstreicht, der das Merkmal enthält, wobei Spektren erzeugt werden, die wie gewünscht individuell oder gemittelt aufgezeichnet werden können;

- die Lichtquelle (208) und der Detektor (210) in einer Kammer (211) enthalten sind, die sich außerhalb der Zelle (201) befindet und vom Probengebiet (202) getrennt ist, wobei die Kammer (211) und das Probengebiet (202) durch mindestens eines des mindestens einen lichtdurchlässigen Fensters (206) in optische Kommunikation miteinander versetzt werden, und Steuern des Drucks innerhalb der Kammer (211) auf einen Wert, der relativ zum atmosphärischen Druck positiv ist.

2. Verfahren zum Detektieren von Gasphasen-Molekülspezies nach Anspruch 1, wobei das Oberwellensignal ein zweites Oberwellensignal ist und die Modulationsamplitude auf das 2,2fache der Breite des Spektralabsorptionsmerkmals aufgrund der detektierten Gasphasen-Molekülspezies im Probengebiet (202) eingestellt ist.

3. Verfahren zum Detektieren von Gasphasen-Molekülspezies nach Anspruch 1, wobei das Oberwellensignal ein viertes Oberwellensignal ist und die Modulationsamplitude auf das 3,9fache der Breite des Spektralabsorptionsmerkmals aufgrund der detektierten Gasphasen-Molekülspezies im Probengebiet (202) eingestellt ist.

4. Verfahren zum Detektieren von Gasphasen-Molekülspezies nach einem der Ansprüche 1 bis 3, weiterhin mit dem Steuern des Drucks innerhalb der Kammer (211), um den Prozentsatz des gemessenen Signals aufgrund der detektierten Gasphasen-Molekülspezies in der Kammer (211) zu maximieren.

5. Verfahren zum Detektieren von Gasphasen-Molekülspezies nach Anspruch 4, wobei der Druck in der Kammer (211) durch Verwendung eines Lochs oder eines Gegendruckreglers gesteuert wird.

6. Verfahren zum Detektieren von Gasphasen-Molekülspezies nach einem der Ansprüche 1 bis 5, bei dem weiterhin ein unter Druck setzendes Gas in die Kammer (211) eingeleitet und wahlweise Gas aus der Kammer (211) abgelassen wird.

7. Verfahren zum Detektieren von Gasphasen-Molekülspezies nach einem der Ansprüche 1 bis 6, wobei die frequenz- und/oder amplitudenmodulierte Lichtquelle (208) ein Diodenlaser ist.

8. Verfahren zum Detektieren von Gasphasen-Molekülspezies nach einem der Ansprüche 1 bis 7, wobei die Molekülspezies Wasserdampf ist.

9. Verfahren zum Detektieren von Gasphasen-Molekülspezies nach einem der Ansprüche 1 bis 8, wobei die Molekülspezies in einem aus einer Kammer (616) oder aus einer bei etwa atmosphärischem Druck betriebenen Kammer abgelassenen Gas detektiert wird.

10. Verfahren zum Detektieren von Gasphasen-Molekülspezies nach Anspruch 9, wobei die Zelle (201) zwischen einer Kammer (616) und einer Vakuumpumpe angeordnet ist und mit diesen in Verbindung steht.

11. Verfahren zum Detektieren von Gasphasen-Molekülspezies nach Anspruch 10, wobei die Kammer (616) eine Partie einer Halbleiterverarbeitungsvorrichtung (615) bildet.

12. Verfahren zum Detektieren von Gasphasen-Molekülspezies nach Anspruch 11, wobei die Halbleiterverarbeitungsvorrichtung (615) ausgewählt ist aus der Gruppe bestehend aus einer Ätzvorrichtung, einer chemischen Dampfabscheidungsvorrichtung, einer Ionenimplantierungsvorrichtung, einer Sputtervorrichtung und einer Vorrichtung zur schnellen thermischen Bearbeitung.

13. Verfahren zum Detektieren von Gasphasen-Molekülspezies nach einem der Ansprüche 1 bis 12, weiterhin mit dem Erzeugen eines Plasmas in der Kammer (616).

14. Verfahren zum Detektieren von Gasphasen-Molekülspezies nach einem der Ansprüche 1 bis 13, weiterhin mit dem Einleiten eines reaktiven Gases in die Kammer (616).

15. Verfahren zum Detektieren von Gasphasen-Molekülspezies nach Anspruch 11, wobei die Vakuumpumpe die Kammer (616) evakuiert.

16. System zum Detektieren von Gasphasen-Molekülspezies in einer Probe durch Oberwellendetektionsspektroskopie, umfassend:

- eine Zelle (201) mit einem Probengebiet (202), das von mindestens einer Wand (203) umschrieben wird und mit mindestens einem Lichteintritts/-austrittskanal (205) darin, wobei jeder Eintritts-/Austrittskanal (205) ein lichtdurchlässiges Fenster (206) mit einer Oberfläche aufweist, die dem Probengebiet (202) zugewandt ist und so angeordnet ist, daß sie die Zelle (201) in Umfangsrichtung abdichtet, wobei die Zelle (201) bei weniger als atmosphärischem Druck arbeiten kann,
- ein System mit frequenz- und/oder amplitudenmodulierter Lichtquelle (208), das eine Lichtquelle (208) umfaßt, um einen Lichtstrahl (209) durch eines des mindestens einen lichtdurchlässigen Fensters (206) in die Zelle (201) zu lenken,
- einen Detektor (210) zum Messen des durch eines des mindestens einen lichtdurchlässigen Fensters (206) aus der Zelle (201) austretenden Lichtstrahls (209),

wobei:

- eine Öffnung sich entlang der Längsachse (204) der Zelle und durch die Zelle (201) erstreckt;
- dieses System Mittel zum Einstellen der Modulationsamplitude der Lichtquelle (208) auf einen Wert umfaßt, der den Wert eines Oberwellensignals in der Mitte des Absorptionsmerkmals aufgrund der detektierten Gasphasen-Molekülspezies innerhalb des Probengebiets (202) maximiert;
- dieses System Mittel zum Justieren der Mittenfrequenz der Lichtquelle (208) aufweist, so daß sie entweder auf die Mitte des Absorptionsmerkmals synchronisiert ist oder wiederholt den Frequenzbereich überstreicht, der das Merkmal enthält, Mittel zum Erzeugen von Spektren, die individuell oder gemittelt aufgezeichnet werden können;
- die Lichtquelle (208) und der Detektor (210) in einer Kammer (211) enthalten sind, die sich außerhalb der Zelle (201) befindet und vom Probengebiet (202) getrennt ist, wobei die Kammer (211) und das Probengebiet (202) durch mindestens eines des mindestens einen lichtdurchlässigen Fensters (206) in optische Kommunikation miteinander versetzt werden, und Mittel zum Steuern des Drucks innerhalb der Kammer (211) auf einen Wert, der relativ zum atmosphärischen Druck positiv ist.

17. System zum Detektieren von Gasphasen-Molekülspezies nach Anspruch 16, wobei das Oberwellensignal ein zweites Oberwellensignal ist und die Modulationsamplitude das 2,2fache der Breite des Spektralabsorptionsmerkmals aufgrund der detektierten Gasphasen-Molekülspezies im Probengebiet (202) beträgt.

18. System zum Detektieren von Gasphasen-Molekülspezies nach Anspruch 16, wobei das Oberwellensignal ein viertes Oberwellensignal ist und der optimale Wert der Modulationsamplitude das 3,9fache der Breite des Spektralabsorptionsmerkmals aufgrund der detektierten Gasphasen-Molekülspezies im Probengebiet (202) beträgt.

19. System zum Detektieren von Gasphasen-Molekülspezies nach einem der Ansprüche 16 bis 18, wobei der Druck innerhalb der Kammer (211) so eingestellt ist, daß der Prozentsatz eines Gesamtsignals aufgrund der detektierten Gasphasen-Molekülspezies in der Kammer (211) maximiert ist.

20. System zum Detektieren von Gasphasen-Molekülspezies nach einem der Ansprüche 16 bis 19, wobei das Druckkontrollmittel der Kammer (211) einen Einlaß für unter Druck setzendes Gas und einen Abgasauslaß umfaßt, die mit der Kammer (211) verbunden sind.

21. System zum Detektieren von Gasphasen-Molekülspezies nach Anspruch 16, wobei das Drucksteuermittel der Kammer (211) weiterhin ein Loch oder einen Gegendruckregler umfaßt.

22. System zum Detektieren von Gasphasen-Molekülspezies nach einem der Ansprüche 16 bis 21, wobei die frequenz- und/oder amplitudenmodulierte Lichtquelle (208) ein Diodenlaser ist.

23. Halbleiterverarbeitungsvorrichtung (615), die folgendes umfaßt:

- eine Kammer (616) und eine Vakuumpumpe in Verbindung damit zum Evakuieren der Kammer;
- ein System nach einem der Ansprüche 16 bis 22,

wobei die Zelle (201) zwischen der Kammer (616) und der Vakuumpumpe angeordnet ist und mit diesen in Verbindung steht.

24. Vorrichtung nach Anspruch 23, wobei die Kammer (616) dafür ausgelegt ist, eine Plasmaatmosphäre zu enthalten.

**25.** Vorrichtung nach Anspruch 23 oder 24, wobei die Kammer (616) dafür ausgelegt ist, eine Atmosphäre aus reaktivem Gas zu enthalten.

**26.** Ätzvorrichtung, die eine Vorrichtung nach einem der Ansprüche 23 bis 25 enthält.

**27.** Chemische Dampfabscheidungsvorrichtung, die eine Vorrichtung nach einem der Ansprüche 23 bis 25 enthält.

**28.** Ionenimplantierungsvorrichtung, die eine Vorrichtung nach einem der Ansprüche 23 bis 25 enthält.

**29.** Sputtervorrichtung, die eine Vorrichtung nach einem der Ansprüche 23 bis 25 enthält.

**30.** Vorrichtung zur schnellen thermischen Verarbeitung, die eine Vorrichtung nach einem der Ansprüche 23 bis 25 enthält.

**Revendications**

**1.** Procédé pour la détection d'une espèce moléculaire en phase gazeuse dans un échantillon par spectroscopie utilisant la détection d'harmoniques, comprenant :

- fourniture d'une cellule (201) comportant une zone d'échantillon (202) qui est circonscrite par au moins une paroi (203), la cellule (201) comportant au moins un orifice d'entrée/sortie de la lumière (205) situé à l'intérieur de celle-ci, chaque orifice d'entrée/sortie de la lumière (205) contenant une fenêtre translucide (206) comportant une surface faisant face à la zone d'échantillon (202) et disposée de façon à assurer l'étanchéité de la cellule (201) dans la direction circonférentielle, la cellule (201) fonctionnant à la pression atmosphérique ou à une pression inférieure à la pression atmosphérique ;
- fourniture d'une source lumineuse modulée en fréquence et/ou en amplitude (208) pour la direction d'un faisceau lumineux (209) à travers une fenêtre translucide qui est ladite fenêtre translucide au moins (206) jusqu'à l'intérieur de la cellule (201) ;
- fourniture d'un détecteur (210) pour mesurer le faisceau lumineux (209) qui sort de la cellule (201) en traversant une fenêtre translucide qui est ladite fenêtre translucide au moins (206) ;

    dans lequel :

- un gaz échantillon circule à travers la zone d'échantillon (202) dans une direction parallèle à un axe central de la cellule (204) ;
- l'amplitude de modulation de la source lumineuse (208) est réglée sur une valeur qui maximise la valeur d'un signal harmonique au centre de la caractéristique d'absorption résultant de l'espèce moléculaire en phase gazeuse qui est détectée à l'intérieur de la zone d'échantillon (202) ;
- la fréquence centrale de la source lumineuse (208) est réglée de façon à être soit verrouillée au centre de la caractéristique d'absorption, soit utilisée pour un balayage répétitif sur la gamme de fréquences qui inclut la caractéristique, des spectres étant produits qui peuvent être enregistrés individuellement ou dont on peut établir la moyenne comme on le souhaite ;
- la source lumineuse (208) et le détecteur (210) sont contenus dans une chambre (211) qui se trouve à l'extérieur de la cellule (201) et qui est isolée de la zone d'échantillon (202), la chambre (211) et la zone d'échantillon (202) étant mises en communication optique l'une avec l'autre par l'intermédiaire d'au moins une fenêtre translucide qui est ladite fenêtre translucide au moins (206), la pression à l'intérieur de la chambre (211) étant contrôlée pour que ladite pression ait une valeur positive par rapport à la pression atmosphérique.

**2.** Procédé pour la détection d'une espèce moléculaire en phase gazeuse selon la revendication 1, dans lequel le signal harmonique est un signal de deuxième harmonique, et l'amplitude de modulation est réglée sur 2,2 fois la largeur de la caractéristique d'absorption spectrale résultant de l'espèce moléculaire en phase gazeuse qui est détectée à l'intérieur de la zone d'échantillon (202).

**3.** Procédé pour la détection d'une espèce moléculaire en phase gazeuse selon la revendication 1, dans lequel le signal harmonique est un signal de quatrième harmonique, et l'amplitude de modulation est réglée sur 3,9 fois la largeur de la caractéristique d'absorption spectrale résultant de l'espèce moléculaire en phase gazeuse qui est détectée à l'intérieur de la zone d'échantillon (202).

**4.** Procédé pour la détection d'une espèce moléculaire en phase gazeuse selon l'une quelconque des revendications 1 à 3, comprenant en outre le contrôle de la pression à l'intérieur de la chambre (211) de façon à maximiser le pourcentage du signal mesuré résultant de l'espèce moléculaire en phase gazeuse qui est détectée à l'intérieur de la chambre (211).

**5.** Procédé pour la détection d'une espèce moléculaire en phase gazeuse selon la revendication 4, dans lequel la pression à l'intérieur de la chambre (211) est contrôlée par l'utilisation d'un orifice ou d'un régulateur de contre-pression.

**6.** Procédé pour la détection d'une espèce moléculaire en phase gazeuse selon l'une quelconque des revendications 1 à 5, comprenant en outre l'introduction d'un gaz de pressurisation dans la chambre (211) et facultativement l'évacuation du gaz de la chambre (211).

**7.** Procédé pour la détection d'une espèce moléculaire en phase gazeuse selon l'une quelconque des revendications 1 à 6, dans lequel la source lumineuse modulée en fréquence et/ou en amplitude (208) est une diode laser.

**8.** Procédé pour la détection d'une espèce moléculaire en phase gazeuse selon l'une quelconque des revendications 1 à 7, dans lequel l'espèce moléculaire est la vapeur d'eau.

**9.** Procédé pour la détection d'une espèce moléculaire en phase gazeuse selon l'une quelconque des revendications 1 à 8, dans lequel l'espèce moléculaire est détectée dans un gaz évacué d'une chambre (616), ou d'une chambre fonctionnant approximativement à la pression atmosphérique.

**10.** Procédé pour la détection d'une espèce moléculaire en phase gazeuse selon la revendication 9, dans lequel la cellule (201) est disposée entre une chambre (616) et une pompe à vide et en communication avec celles-ci.

**11.** Procédé pour la détection d'une espèce moléculaire en phase gazeuse selon la revendication 10, dans lequel la chambre (616) forme une partie d'un appareil de traitement de semi-conducteurs (615).

**12.** Procédé pour la détection d'une espèce moléculaire en phase gazeuse selon la revendication 11, dans lequel l'appareil de traitement de semi-conducteurs (615) est sélectionné dans le groupe constitué d'un appareil d'attaque chimique, d'un appareil de dépôt chimique en phase vapeur, d'un appareil d'implantation d'ions, d'un appareil de pulvérisation cathodique et d'un appareil de traitement thermique rapide.

**13.** Procédé pour la détection d'une espèce moléculaire en phase gazeuse selon l'une quelconque des revendications 1 à 12, comprenant en outre la production d'un plasma dans la chambre (616).

**14.** Procédé pour la détection d'une espèce moléculaire en phase gazeuse selon l'une quelconque des revendications 1 à 13, comprenant en outre l'introduction d'un gaz réactif dans la chambre (616).

**15.** Procédé pour la détection d'une espèce moléculaire en phase gazeuse selon la revendication 11, dans lequel la pompe à vide assure l'évacuation de la chambre (616).

**16.** Système pour la détection d'une espèce moléculaire en phase gazeuse dans un échantillon par spectroscopie utilisant la détection d'harmoniques, comprenant :

- cellule (201) comportant une zone d'échantillon (202) qui est circonscrite par au moins une paroi (203), et au moins un orifice d'entrée/sortie de la lumière (205) situé à l'intérieur de celle-ci, chaque orifice d'entrée/sortie de la lumière (205) contenant une fenêtre translucide (206) comportant une surface faisant face à la zone d'échantillon (202) et disposée de façon à assurer l'étanchéité de la cellule (201) dans la direction circonférentielle, la cellule (201) étant capable de fonctionner à une pression inférieure à la pression atmosphérique ;
- système de source lumineuse modulée en fréquence et/ou en amplitude (208) comprenant une source lumineuse (208) pour la direction d'un faisceau lumineux (209) à travers une fenêtre translucide qui est ladite fenêtre translucide au moins (206) jusqu'à l'intérieur de la cellule (201) ;
- détecteur (210) pour mesurer le faisceau lumineux (209) qui sort de la cellule (201) en traversant une fenêtre translucide qui est ladite fenêtre translucide au moins (206) ;

dans lequel :

- une ouverture s'étend le long de l'axe longitudinal (204) de ladite cellule et à travers ladite cellule (201) ;
- ce système comprend un moyen de réglage de l'amplitude de modulation de la source lumineuse (208) sur une valeur qui maximise la valeur d'un signal harmonique au centre de la caractéristique d'absorption résultant de l'espèce moléculaire en phase gazeuse qui est détectée à l'intérieur de la zone d'échantillon (202) ;
- ce système comprend un moyen de réglage de la fréquence centrale de la source lumineuse (208) de façon à ce qu'elle soit verrouillée au centre de la caractéristique d'absorption, ou bien utilisée pour un balayage répétitif sur la gamme de fréquences qui inclut la caractéristique, constituant un moyen de production de spectres qui peuvent être enregistrés individuellement ou dont on peut établir la moyenne ;
- la source lumineuse (208) et le détecteur (210) sont contenus dans une chambre (211) qui se trouve à l'extérieur de la cellule (201) et qui est isolée de la zone d'échantillon (202), la chambre (211) et la zone d'échantillon (202) étant en communication optique l'une avec l'autre par l'intermédiaire d'au moins une fenêtre translucide qui est ladite fenêtre translucide au moins (206), avec un moyen de contrôle de la pression à l'intérieur de la chambre (211) pour que ladite pression ait une valeur positive par rapport à la pression atmosphérique.

17. Système pour la détection d'une espèce moléculaire en phase gazeuse selon la revendication 16, dans lequel le signal harmonique est un signal de deuxième harmonique, et l'amplitude de modulation est de 2,2 fois la largeur de la caractéristique d'absorption spectrale résultant de l'espèce moléculaire en phase gazeuse qui est détectée à l'intérieur de la zone d'échantillon (202).

18. Système pour la détection d'une espèce moléculaire en phase gazeuse selon la revendication 16, dans lequel le signal harmonique est un signal de quatrième harmonique, et la valeur optimum de l'amplitude de modulation est de 3,9 fois la largeur de la caractéristique d'absorption spectrale résultant de l'espèce moléculaire en phase gazeuse qui est détectée à l'intérieur de la zone d'échantillon (202).

19. Système pour la détection d'une espèce moléculaire en phase gazeuse selon l'une quelconque des revendications 16 à 18, dans lequel la pression à l'intérieur de la chambre (211) est réglée de façon à maximiser le pourcentage d'un signal total résultant de l'espèce moléculaire en phase gazeuse qui est détectée à l'intérieur de la chambre (211).

20. Système pour la détection d'une espèce moléculaire en phase gazeuse selon l'une quelconque des revendications 16 à 19, dans lequel le moyen de contrôle de la pression dans la chambre (211) comprend une entrée de gaz de pressurisation et une sortie d'évacuation du gaz qui est connectée à la chambre (211).

21. Système pour la détection d'une espèce moléculaire en phase gazeuse selon la revendication 16, dans lequel le moyen de contrôle de la pression dans la chambre (211) comprend en outre un orifice ou un régulateur de contre-pression.

22. Système pour la détection d'une espèce moléculaire en phase gazeuse selon l'une quelconque des revendications 16 à 21, dans lequel la source lumineuse modulée en fréquence et/ou en amplitude (208) est une diode laser.

23. Appareil de traitement de semi-conducteurs (615), comprenant :

- chambre (616) et pompe à vide en communication avec celle-ci pour l'évacuation de ladite chambre ;
- système selon l'une quelconque des revendications 16 à 22, la cellule (201) étant disposée entre ladite chambre (616) et ladite pompe à vide et en communication avec celles-ci.

24. Appareil selon la revendication 23, dans lequel la chambre (616) est adaptée pour contenir une atmosphère de plasma.

25. Appareil selon la revendication 23 ou 24, dans lequel la chambre (616) est adaptée pour contenir une atmosphère de gaz réactif.

26. Appareil d'attaque chimique comprenant un appareil selon l'une quelconque des revendications 23 à 25.

27. Appareil de dépôt chimique en phase vapeur comprenant un appareil selon l'une quelconque des revendications 23 à 25.

28. Appareil d'implantation d'ions comprenant un appareil selon l'une quelconque des revendications 23 à 25.

**29.** Appareil de pulvérisation cathodique comprenant un appareil selon l'une quelconque des revendications 23 à 25.

**30.** Appareil de traitement thermique rapide comprenant un appareil selon l'une quelconque des revendications 23 à 25.

FIG. 1

FIG. 2A

FIG. 2B

FIG. 3

FIG. 4

FIG. 5

FIG. 6